# EUROPÄISCHE PATENTSCHRIFT

(11) **EP 2 102 096 B1**
(45) Veröffentlichungstag und Bekanntmachung des Hinweises auf die Patenterteilung: **24.08.2016**
(21) Anmeldenummer: 08707087.6
(22) Anmeldetag: 17.01.2008
(51) Int. Cl.: B81B 7/00, B81C 1/00, G02B 26/08, B81B 3/00

(54) **GEHÄUSE FÜR IN MOBILEN ANWENDUNGEN EINGESETZTE MIKROMECHANISCHE UND MIKROOPTISCHE BAUELEMENTE**
HOUSING FOR MICRO-MECHANICAL AND MICRO-OPTICAL COMPONENTS USED IN MOBILE APPLICATIONS
BOÎTIER DESTINÉ À DES COMPOSANTS MICRO-MÉCANIQUES ET MICRO-OPTIQUES EMPLOYÉS DANS DES APPLICATIONS MOBILES

(30) Priorität: 18.01.2007 DE 102007002725
(43) Veröffentlichungstag der Anmeldung: 23.09.2009
(73) Patentinhaber: Fraunhofer-Gesellschaft zur Förderung der angewandten Forschung e.V., 80686 München (DE)
(72) Erfinder: HOFMANN, Ulrich, 25524 Itzehoe (DE); OLDSEN, Marten, 22761 Hamburg (DE)
(86) Internationale Anmeldenummer: PCT/EP2008/000321
(87) Internationale Veröffentlichungsnummer: WO 2008/087022

(56) Entgegenhaltungen:
- WO-A-01/04680
- US-A1- 2002 178 817
- US-A1- 2004 025 589
- US-A1- 2006 144 143
- US-A1- 2006 272 413

## Beschreibung

### Technisches Gebiet

Fertig prozessierte mikromechanische (MEMS) und mikrooptische Systeme (MOEMS) beziehungsweise Bauelemente - wie zum Beispiel Beschleunigungssensoren, Drehratensensoren, Mikrospiegel - bestehen in der Regel aus sehr empfindlichen, zum Teil frei beweglichen Mikrostrukturen (zum Beispiel Balken, Gittern, Platten).

Während der meisten zur Herstellung benötigten Fertigungsschritte (zum Beispiel Schichtabscheidung, Photo-Lithographie, Ätzverfahren) sind auch die beweglichen Mikrostrukturen noch fest und dadurch unbeweglich mit dem Substrat (Trägersubstrat), üblicherweise einem Wafer (Trägerwafer), verbunden. Erst durch einen sogenannten " Release"-Prozess werden diese Mikrostrukturen frei beweglich. Ab diesem Zeitpunkt sind die beweglichen Mikrostrukturen besonders empfindlich, so dass Verunreinigungen oder mechanische Überbeanspruchungen zur Zerstörung oder Funktionseinschränkung dieser Mikrostrukturen und damit zur Dysfunktion des Bauelements führen können. So kommt beispielsweise bei der Vereinzelung eines Wafers, also dem Zersägen eines Wafers in einzelne Chips, die Waferoberfläche und damit die Mikrostrukturen der MEMS/MOEMS mit Partikeln und Wasser in Berührung. Des Weiteren können die Mikrostrukturen während eines Sägeprozesses relativ starken mechanischen Belastungen ausgesetzt sein.

Um dennoch MEMS/MOEMS mit hoher Ausbeute kostengünstig fertigen zu können, ist man bestrebt, sowohl den "Release"-Prozess als auch Maßnahmen insbesondere zum Schutz der beweglichen Mikrostrukturen bereits durchzuführen, bevor das Substrat vereinzelt beziehungsweise zerteilt wird.

Die Erfindung betrifft ein Gehäuse zur Verkapselung mikromechanischer und mikrooptischer Bauelemente, welche insbesondere in mobilen Geräten zum Einsatz kommen, und ein Verfahren zur Herstellung eines solchen Gehäuses, wobei sich das Verfahren auch für die Verkapselung der MEMS/MOEMS auf Substrat-Ebene insbesondere auf Wafer-Ebene, d.h. vor dem Vereinzelungsprozess und damit vor der Zerteilung des Substrats, eignet.

### Stand der Technik

Gehäuse zur Verkapselung von MEMS/MOEMS sowie Verfahren zu Herstellung solcher Gehäuse insbesondere auf Wafer-Ebene, sogenannte Wafer-Level-Packaging-Verfahren, sind aus der Halbleiterindustrie bekannt.

Wie beispielsweise in der US 6,743,656 beschrieben, wird der Wafer (Trägerwafer) mit den MEMS/MOEMS mit einem weiteren Wafer (Deckelwafer), der über Vertiefungen definierter Abmaße verfügt, verbunden. In der Regel handelt es sich bei den Wafern um Siliziumwafer, so dass auch die Vertiefungen im Deckelwafer mit den bewährten Verfahren der Siliziumtechnologie einfach und präzise hergestellt werden können. Im anschließenden Vereinzelungsprozess, überlicherweise einem Sägeprozess, werden dann separate gekapselte Chips erzeugt, ohne dass Kontaminationsgefahr für die MEMS/MOEMS besteht.

Sollen die MEMS/MOEMS eine optische Funktion ausüben oder sollen bestimmte Parameter oder physikalische Größen der MEMS/MOEMS optisch gemessen werden - beispielsweise Bestimmung der Auslenkung mittels Interferometer oder durch Auswertung von Videosequenzen - dann bedarf es in der Regel eines optisch transparenten Deckelsubstrats.

In der WO 2004/1068665 wird ein Wafer-Level-Packaging-Verfahren für MOEMS beschrieben, welches ein Deckelsubstrat aus Glas vorsieht. Vor dem Verkapselungsprozess wird der Wafer mit den MOEMS allerdings vereinzelt. Die daraus resultierenden separaten ungekapselten Chips (DIEs) werden auf einem neuen Substrat platziert, montiert, kontaktiert und erst anschließend gekapselt.

In der US6146917 wird ein Wafer-Level-Packaging-Verfahren für MEMS/MOEMS beschrieben, bei dem ein mit Vertiefungen versehener Deckelwafer aus Silizium oder Glas durch Fusions-Bonden oder Anodisches Bonden mit dem Trägerwafer verbunden wird, woraus ein hermetisch dichtes Gehäuse resultiert. Die Herstellung der erforderlichen 50 bis 150 µm tiefen Vertiefungen im Deckelwafer aus Silizium kann durch naßchemisches Ätzen mittels KOH-Lösung erfolgen und sei auch auf Glaswafer übertragbar.

In der US2005/0184304 wird ein Wafer-Level-Packaging-Verfahren zur Verkapselung von oberflächenmikromechanisch gefertigten Mikrospiegel-Arrays vorgestellt. Ein Deckelwafer aus Glas besitzt Vertiefungen, die als optische Fenster dienen und auch über entsprechende Vergütungsschichten verfügen können. Die Vertiefungen im Deckelwafer können Tiefen von über 100 µm aufweisen.

Aus dem Patent US 5,591,679 ist ein Verfahren zur Herstellung eines hermetisch dichten Gehäuses sowohl für oberflächenmikromechanisch als auch volumenmikromechanisch gefertigte MEMS/MOEMS bekannt. Danach genügt im Fall oberflächenmikromechanischer MEMS/MOEMS ein mit Vertiefungen versehener Deckelwafer aus Glas, der auf den Trägerwafer aus Silizium anodisch gebondet wird. Für volumenmikromechanisch hergestellte MEMS/MOEMS wird neben dem ersten Deckelwafer auf der ersten Seite des Trägerwafers ein zweiter Deckelwafer für die der ersten Seite des Trägerwafers gegenüberliegende zweite Seite des Trägerwafers vorgesehen. Durch die Einstellung eines definierten Abstands zwischen Trägerwafer und zweitem Deckelwafer kann der zweite Deckelwafer als mechanischer Anschlag gegen mechanische Überlast dienen.

In der US2004/0025589 wird ein Wafer-Level-Packaging- Verfahren für MEMS beschreiben, bei dem ein Glasdeckelsubstrat der ein mechanischer Anschlag enthält mit ein Trägersubstrat verbunden wird. Der mechanische Anschlag ist einstückig mit dem Glasdeckelsubstrat.

### Beschreibung

Der vorliegenden Erfindung liegt die Aufgabe zugrunde, die Nachteile des Standes der Technik zu überwinden und ein Gehäuse zur Verfügung zu stellen, das insbesondere für optische Anwendungen geeignet ist, einen mechanischen Überlastschutz aufweist und auf Substrat- beziehungsweise Wafer-Ebene hergestellt werden kann.

Gemäß der vorliegenden Erfindung wird die Aufgabe durch ein Gehäuse gemäß Anspruch 1 gelöst. Anspruch 6 gibt ein Verfahren zur Herstellung des erfindungsgemäßen Gehäuses an.

Die Unteransprüche lehren vorteilhafte Weiterbildungen;

Das erfindungsgemäße Gehäuse dient der Verkapselung von einem oder mehreren mikromechanischen und/oder mikrooptischen Bauelement/en und weist ein Trägersubstrat, mit mindestens einem mikromechanischen und/oder mikrooptischen Bauelement, und mindestens ein Deckelsubstrat auf. Das Trägersubstrat und das Deckelsubstrat stehen miteinander in Verbindung, bevorzugt stoffschlüssig in Verbindung, und bilden einen oder mehrere Hohlräume, der/die das mindestens eine mikromechanische und/oder mikrooptische Bauelement zumindest teilweise einschließt. Die dem mindestens einen mikromechanischen und/oder mikrooptischen Bauelement zugewandte Seite des Deckelsubstrats weist mindestens ein optisches Fenster und mindestens einen mechanischen Anschlag auf.

Ein Gehäuse zur Verkapselung von MEMS/MOEMS, insbesondere beweglichen MEMS/MOEMS, soll in der Regel mindestens einen Schutz gegen Verunreinigungen bieten und gleichzeitig die mechanische und/oder optische Funktionalität der MEMS/MOEMS nicht beeinträchtigen. Als Gehäuse kann beispielsweise ein Deckelsubstrat fungieren, das mit dem Trägersubstrat in Verbindung steht. Sollte die Funktionalität der MEMS/MOEMS nicht nur auf Bewegungen in der beziehungsweise parallel zur Trägersubstratebene beschränkt sein, sondern auch Bewegungen senkrecht zur Trägersubstratebene vorsehen, muss das Gehäuse den MEMS/MOEMS entsprechende Bewegungsfreiheit gewährleisten.

So kann das Deckelsubstrat beispielsweise Vertiefungen aufweisen, die in Verbindung mit dem Trägersubstrat Hohlräume um die MEMS/MOEMS bilden, so dass die Funktionalität der MEMS/MOEMS nicht eingeschränkt wird.

Um auch sehr vibrations- und schockempfindliche MEMS/MOEMS mit weichen Aufhängungen und niedrigen Resonanzfrequenzen mit hoher Ausbeute fertigen zu können, bedarf es Anschlägen, die die MEMS/MOEMS vor mechanischer Überlast (zum Beispiel Schock, Vibrationen, usw.), wie sie beispielsweise bei mobilen Anwendungen (zum Beispiel in Mobiltelefonen) auftreten kann, schützen.

Während laterale Kräfte, die in der Substratebene wirken, durch laterale Anschläge im MEMS/MOEMS-Design vorgesehen und entsprechend realisiert werden können, bedarf es für senkrecht aus der Substratebene wirkende Kräfte zusätzlicher vertikaler Anschläge.

Das erfindungsgemäße Gehäuse weist einen oder mehrere integrierte mechanische Anschläge auf, der/die bevorzugt an einer beliebigen Stelle aus dem Deckelsubstrat in Richtung der MEMS/MOEMS ragt/ragen.

Durch ein Herausragen der Anschläge insbesondere aus der den MEMS/MOEMS zugewandten Fläche der optischen Fenster kann verhindert werden, dass Bereiche der MEMS/MOEMS mit den größten Auslenkungsamplituden - und damit zum Beispiel bei Rotationsbewegungen mit der höchsten Geschwindigkeit - am Deckelsubstrat anstoßen. In Verbindung mit der freien Wahl der Position der Anschläge besteht die Möglichkeit, dass man Bereiche der MEMS/MOEMS für den Kontakt mit den Anschlägen vorsieht, die am besten dafür geeignet sind; zum Beispiel weil deren maximale vertikale Geschwindigkeit im Vergleich zu anderen Bereichen gering ist, sie keine aktive Funktion ausüben beziehungsweise keine aktiven Bereiche darstellen und/oder diese Bereiche mechanisch besonders stabil ausgelegt sind.

Damit lässt sich das Risiko einer Beschädigung der Mikrostrukturen und damit der MEMS/MOEMS bei mechanischen Überbeanspruchungen reduzieren.

Prinzipiell sollten die mechanischen Anschläge die Funktionalität beziehungsweise den gewünschten Arbeitsbereich der MEMS/MOEMS nicht einschränken, wobei der Abstand der mechanischen Anschläge zu den für den Kontakt mit den Anschlägen vorgesehenen Bereichen der MEMS/MOEMS bevorzugt möglichst gering sein sollte.

Bei manchen Anwendungen hat das Gehäuse auch optische Funktionen zu erfüllen. Das erfindungsgemäße Gehäuse bietet durch die herausragenden Anschläge den Vorteil, dass es bei mechanischen Überbeanspruchungen nur zum Kontakt der MEMS/MOEMS mit den Anschlägen kommt. Andere Bereiche des Deckelsubstrats kommen nicht mit den MEMS/MOEMS in Berührung. Dadurch werden die anderen Bereiche des Deckelsubstrats, die beispielsweise als optische Fenster fungieren, nicht beschädigt oder in ihrer Funktionalität beeinträchtigt.

Unter einem optischen Fenster wird erfindungsgemäß ein Bereich des Gehäuses verstanden, der für beliebige Wellenlängen und/oder Wellenlängenbereiche elektromagnetischer Strahlung - insbesondere die durch das zu verkapselnde MEMS/MOEMS zu verarbeitende Strahlung und damit die in der Anwendung eingesetzte Strahlung - aus dem infraroten, sichtbaren (Licht) und ultravioletten Frequenzbereich durchlässig, insbesondere transparent, ist und zudem üblicherweise hohe Qualitätsanforderungen insbesondere an die Oberflächenrauhigkeit, die Ebenheit und die Planparallelität erfüllt. Des Weiteren sollten diese Bereiche vorzugsweise eine homogene Materialstruktur aufweisen.

Ein typisches mikrooptisches Bauelement ist der Mikrospiegel, der zum Beispiel in der Video-Laser-Projektion als Scanspiegel eingesetzt werden kann, um einen einfallenden Laserstrahl abzulenken. Dabei soll der Laserstrahl durch das Gehäuse möglichst wenig gestreut und deformiert werden.

Zur Erzeugung der Hohlräume zwischen Trägersubstrat und Deckelsubstrat wird beispielsweise das Deckelsubstrat mit Vertiefungen versehen, so dass Trägersubstrat und Deckelsubstrat nach ihrer Verbindung die MEMS/MOEMS in der Regel komplett umschließen. Bei den meisten Anwendungen sind Tiefen zwischen etwa 50 µm und 900 µm für die Vertiefungen ausreichend. Um auch größeren MEMS/MOEMS ausreichend Auslenkungsfreiheit gewähren zu können, sind Vertiefungen im Deckelsubstrat tiefer 900 µm von Vorteil.

Solche Vertiefungen sind beispielsweise für relativ große beweglich aufgehängte Mikrospiegel zweckmäßig, die einen Durchmesser von 10 mm haben können. Ein Verkippen eines so dimensionierten Mikrospiegels um 10° um seine Mittelachse führt zu einer maximalen aus der Substratebene gerichteten Auslenkung von fast 870 µm.

Besonders vorteilhaft ist es, wenn das Gehäuse die MEMS/MOEMS hermetisch dicht von der Umgebung abschließt, so dass im Gehäuse eine bestimmte Atmosphäre einstellbar ist. Dadurch ist ein besonders guter Schutz gegen Verunreinigungen gegeben, wodurch die Gefahr einer Dysfunktion des verkapselten MEMS/MOEMS minimiert wird. Zudem lässt sich in den Hohlräumen eine von der Umgebung unabhängige Atmosphäre einstellen.

Während bei oberflächenmikromechanisch gefertigten MEMS/MOEMS eine hermetisch dichte Verkapselung bereits durch einen Verbund aus Trägersubstrat und einem Deckelsubstrat erreicht werden kann, bedarf es bei volumenmikromechanisch gefertigten MEMS/MOEMS, welche zum Teil vollständig durch das Trägersubstrat hindurch geätzte Mikrostrukturen besitzen, mindestens eines zweiten Deckelsubstrats, das mit der der ersten Seite des Trägersubstrats, die mit dem ersten Deckelsubstrat in Verbindung steht, gegenüberliegenden zweiten Seite des Trägersubstrats verbunden wird, so dass das Trägersubstrat beidseitig mit Deckelsubstraten versehen ist.

In vielen Anwendungsfällen wird ein Gehäuseinnendruck unterhalb des atmosphärischen Luftdrucks bevorzugt. Für MEMS/MOEMS besonders bevorzugt wird ein Gehäuseinnendruck von etwa 10⁻³ mbar bis etwa 1 mbar. Dadurch lässt sich beispielsweise die Dämpfung insbesondere bei Systemen, die bei Resonanz betrieben werden, reduzieren und dadurch höhere Gütefaktoren und größere Auslenkungsamplituden erzielen.

Bei anderen Anwendungen ist es vorteilhaft, wenn die Hohlräume mit einem Gas gefüllt sind, um dadurch bestimmte Eigenschaften der MEMS/MOEMS gezielt zu beeinflussen. Dabei kommen Gase in Frage, die trocken und nicht elektrisch leitfähig sind, mit den für das Gehäuse und die MEMS/MOEMS verwendeten Materialien chemisch nicht reagieren und die erforderliche Transparenz aufweisen; als Beispiele seien Inertgase wie Edelgase, Stickstoff oder SF₆ genannt.

So wird beispielsweise bei Anwendungen, bei denen Wärme möglichst schnell an das Gehäuse und die Umgebung abgeleitet werden soll, Argon als Gehäuseatmosphärengas eingesetzt, da Argon elektrisch nicht leitfähig ist, trotzdem aber eine relativ hohe thermische Leitfähigkeit besitzt. Zudem ist die Diffusionsneigung von Argon so gering, dass langzeitstabile Druckverhältnisse im Gehäuse möglich sind.

Als Trägersubstrat werden bevorzugt Siliziumwafer verwendet, da die Prozesse der Siliziumtechnologie ausgereift sind und gut beherrscht werden.

Insbesondere für bewegliche MEMS/MOEMS, die bei optischen Anwendungen zum Einsatz kommen, ist ein Gehäuse notwendig, das zumindest in Teilbereichen den oben genannten Anforderungen an ein optisches Fenster entspricht sowie neben der mechanischen auch die optische Funktionalität des gekapselten MEMS/MOEMS möglichst nicht beziehungsweise wenig beeinträchtigt.

Daher ist es von Vorteil, wenn sich die thermischen Ausdehnungskoeffizienten von Trägersubstrat und Deckelsubstrat möglichst gering unterscheiden oder zwischen den beiden Substraten eine Schicht angeordnet ist, mit der die unterschiedlichen Ausdehnungskoeffizienten ausgeglichen werden können.

Dadurch lassen sich thermisch induzierte mechanische Spannungen zwischen Trägersubstrat und Deckelsubstrat minimieren und die Gefahr von Schädigungen am Gehäuse und den gekapselten MEMS/MOEMS reduzieren.

Das Deckelsubstrat enthält oder besteht bevorzugt aus Glas und/oder einem glasähnlichen Material. Unter glasähnlichen Materialien werden erfindungsgemäß Stoffe verstanden, die wegen ihrer thermodynamischen Eigenschaften (amorpher Aufbau, Glasübergangstemperatur) Gläsern ähneln, obwohl sich ihre chemische Zusammensetzung von der der Silikatgläser unterscheidet. Als Beispiele seien hier die in der Chemie bekannten Kunstgläser oder organischen Vitroide wie Polymethylmethacrylate (PMMA), Polycarbonat und Polystyrol genannt.

Besonders geeignete Gläser sind Silikatgläser, insbesondere Borsilikatgläser, da Borsilikatgläser sehr chemikalien- und temperaturbeständig sind. Die Temperaturbeständigkeit und Unempfindlichkeit der Borsilikatgläser gegen plötzliche Temperaturschwankungen sind eine Folge ihres geringen Wärmeausdehnungskoeffizienten. Zudem ist der Transmissionsgrad insbesondere im sichtbaren Bereich mit über 90% sehr hoch.

Um optischen Qualitätsansprüchen gerecht zu werden, sollten die optischen Fenster des Gehäuses eine Ebenheits- und/oder Planparallelitätsabweichung kleiner einem Viertel der Wellenlänge der bei der Anwendung eingesetzten elektromagnetischen Strahlung aufweisen, wobei üblicherweise Wellenlängen vom ultravioletten bis in den infraroten Wellenlängenbereich (zum Beispiel zwischen etwa 200 nm und etwa 15 µm) Anwendung finden. Demzufolge sind bei längerwelligem Licht mit Wellenlängen unter 720 nm Werte für die Ebenheits- und/oder Planparallelitätsabweichung kleiner 180 nm von Vorteil. Bei Verwendung von kürzerwelligem Licht mit Wellenlängen unter 440 nm steigen die Anforderungen an die optischen Fenster, so dass Werte für die Ebenheits- und/oder Planparallelitätsabweichung kleiner 110 nm bevorzugt werden.

Optische Fenster, die diese Anforderungen erfüllen, verursachen geringere Abweichungen und eine geringere Strahlaufweitung des optischen Strahlenverlaufs, was zu einer geringeren Verfälschung der optischen Signale führt.

Zudem sollte die quadratische Oberflächenrauhigkeit der optischen Fenster möglichst gering sein, bevorzugt kleiner 15 nm, besonders bevorzugt kleiner 5 nm. Dadurch lässt sich insbesondere die durch das Deckelsubstrat verursachte Streuung reduzieren.

Die Werte für die Ebenheits- und Planparallelitätsabweichung sowie für die quadratische Oberflächenrauhigkeit wurden mittels interferometrischer Messmethode bestimmt. Für die Messungen wurde das Weißlicht- und Phaseninterferometer MicroMap 512 der Firma Atos verwendet.

Um die Eigenschaften der optischen Fenster zusätzlich zu optimieren, ist es von Vorteil, diese Bereiche zumindest teilweise mit Veredlungsschichten zu versehen.

Besonders häufig eingesetzte Veredlungsschichten sind beispielsweise Entspiegelungsschichten, die Reflexionen an den optischen Fenstern und damit Strahlungsverluste verringern. Solche Entspiegelungsschichten lassen sich zum Beispiel durch Schichtsysteme aus Magnesiumfluorid und Titanoxid oder Siliziumdioxid und Titandioxid realisieren.

Des Weiteren finden Antistatik-Schichten, die ein elektrisches Aufladen des Deckelsubstrats minimieren, häufig Verwendung. Ein für Antistatik-Schichten in optischen Anwendungen besonders geeignetes Material ist ITO (Indiumzinnoxid), da es dotiert eine hohe elektrische Leitfähigkeit aufweist und über einen breiten Frequenzbereich eine hohe Transparenz aufweist.

Weiterhin können Reflexionsschichten, zum Beispiel Metallschichten, aufgebracht werden, die nach Strukturierung lokal reflektierende Bereiche bilden, zum Beispiel um einen einfallenden Lichtstrahl räumlich zu begrenzen (Blendenfunktion) oder um in Nachbarschaft zu den optischen Fenstern einen statischen Umlenkspiegel zu bilden. Bevorzugt eingesetzte Veredlungsschichten sind des Weiteren Absorberschichten, die elektromagnetische Strahlung bestimmter Wellenlängen oder ganzer Wellenlängenbereiche absorbieren.

Das erfindungsgemäße Verfahren zur Herstellung eines Gehäuses zur Verkapselung mikromechanischer und/oder mikrooptischer Bauelemente weist die folgenden Schritte auf:
- Bereitstellen eines Trägersubstrats mit mindestens einem mikromechanischen und/oder mikrooptischen Bauelement
- Bereitstellen mindestens eines Deckelsubstrats, das mindestens ein optisches Fenster und mindestens einen mechanischen Anschlag aufweist
- Verbinden des Trägersubstrats mit dem mindestens einen Deckelsubstrat derart, dass das Trägersubstrat und das mindestens eine Deckelsubstrat mindestens einen Hohlraum bilden, der das mindestens eine mikromechanische und/oder mikrooptische Bauelement zumindest teilweise einschließt.

Das erfindungsgemäße Verfahren dient der Verkapselung von MEMS/MOEMS, die üblicherweise auf einem Trägersubstrat aufgebracht oder angeordnet sind. Üblicherweise findet als Trägersubstrat ein Siliziumwafer Anwendung, auf dem durch oberflächenmikromechanische oder volumenmikromechanische Prozesse die zu verkapselnden MEMS/MOEMS erzeugt werden.

Für die Verkapselung ist des Weiteren ein Deckelsubstrat erforderlich, welches üblicherweise bereits vor der Erzeugung der optischen Fenster und der mechanischen Anschläge zumindest in Teilbereichen, im Regelfall in seiner Gesamtheit, für die in der Anwendung eingesetzte elektromagnetische Strahlung durchlässig ist. Bei den meisten optischen Anwendungen wird allerdings eine möglichst hohe Transparenz dieser für die in der Anwendung eingesetzte elektromagnetische Strahlung durchlässigen Bereiche gefordert, damit beispielsweise ein Laserstrahl möglichst unbeeinflusst das MEMS/MOEMS erreicht.

Auch um diesen Ansprüchen gerecht zu werden, wird das Deckelsubstrat üblicherweise strukturiert. Hierbei werden Vertiefungen für die Hohlräume, die optischen Fenster und die mechanischen Anschläge erzeugt.

Als Deckelsubstrat eignen sich - wie vorstehend erläutert - verschiedene Gläser sowie bestimmte glasähnliche Kunststoffe. Verschiedene in der Siliziumtechnologie verwendete Strukturierungsverfahren lassen sich auch für Glassubstrate nutzen. So könnten beispielsweise die Vertiefungen mit HF-Lösung geätzt werden. Allerdings führt naßchemisches strukturiertes Ätzen von Glassubstraten in der Regel zu beträchtlichen Inhomogenitäten bezüglich der Ätztiefe innerhalb der geätzten Flächen (ungenügende Planparallelität der Flächen) und darüber hinaus zu stark angerauten Oberflächen, und zwar umso stärker je tiefer geätzt wird. In der Regel ist ein so strukturiertes Deckelsubstrat für optische Einsatzzwecke ungeeignet.

Um qualitativ hochwertige optische Oberflächen zu erhalten, eignet sich zur Strukturierung des Deckelsubstrats beispielsweise ein Glasfließ-Verfahren, bei dem die Strukturen eines Formsubstrats beispielsweise auf ein Glassubstrat abgeformt werden. Dabei wird die Oberflächenqualität des Glassubstrats hauptsächlich durch die Oberflächenqualität des Formsubstrats bestimmt.

In einer vorteilhaften Ausgestaltung werden nach dem Strukturieren des Deckelsubstrats insbesondere die optischen Fenster zumindest teilweise mit einer Entspiegelungsschicht und/oder einer Antistatik-Schicht und/oder einer Reflexionsschicht und/oder einer Absorberschicht versehen, wodurch sich die optische Funktionalität des Gehäuses verbessern lässt.

In einem weiteren Verfahrensschritt werden das Trägersubstrat und das mindestens eine Deckelsubstrat miteinander verbunden, so dass das Trägersubstrat und das mindestens eine Deckelsubstrat mindestens einen Hohlraum bilden, der das MEMS/MOEMS zumindest teilweise einschließt.

Dafür sind generell alle zweckmäßigen Verbindungstechniken einsetzbar wie zum Beispiel Kleben, Löten oder Bonden.

In einer bevorzugten Ausgestaltung werden das Trägersubstrat und das mindestens eine Deckelsubstrat durch anodisches und/oder eutektisches Bonden und/oder Glasfritt-Bonden miteinander verbunden. Vor allem in der Halbleiterindustrie sind diese Bondverfahren häufig eingesetzte Verbindungstechniken insbesondere zur hermetisch dichten Verkapselung von Bauelementen.

Eutektisches Bonden wird besonders bevorzugt, wenn von den MEMS/MOEMS absorbierte Energie, zum Beispiel Strahlungsenergie, auf das Deckelsubstrat abgeführt werden soll.

Je nachdem in welcher Umgebung der Bondprozess des Deckelsubstrats beziehungsweise der Deckelsubstrate durchgeführt wird, kann eine ganz bestimmte Atmosphäre - zum Beispiel ein Druck unterhalb des atmosphärischen Luftdrucks, besonders bevorzugt zwischen etwa 10⁻³ mbar und etwa 1 mbar, und/oder eine Inertgas-Füllung, zum Beispiel mit Argon - in einem hermetisch dichten Gehäuse erzeugt werden. Es werden daher bevorzugt Verbindungstechniken gewählt, die eine stabile Atmosphäre im Gehäuse gewährleisten können.

Das erfindungsgemäße Verfahren ist besonders bevorzugt auf Wafer-Ebene als Wafer-Level-Packaging-Verfahren einsetzbar, wodurch sich mehrere MEMS/MOEMS gleichzeitig verkapseln lassen und damit ein zeitsparendes und effektives Verkapselungsverfahren gegeben ist.

Bevorzugt wird das Verfahren zur Verkapselung von beweglichen Mikrospiegeln und/oder Mikrospiegel-Arrays eingesetzt.

### Beispiele

Ohne Einschränkung der Allgemeinheit wird die Erfindung anhand schematischer Zeichnungen und eines Ausführungsbeispiels nachfolgend näher beschrieben.
Fig. 1 zeigt ein mit zwei transparenten Deckelwafern 2, 3 verkapselten volumenmikromechanisch gefertigten Mikrospiegel 12, der an Torsionsfedern 11 aufgehängt ist.
Fig. 2 zeigt ein mit einem transparenten 2 und einem nicht transparenten ebenen Deckelwafer 3 verkapselten volumenmikromechanisch gefertigten Mikrospiegel 12, der an Torsionsfedern 11 aufgehängt ist.
Fig. 3 zeigt ein mit einem transparenten 2 und einem nicht transparenten, mit einer Vertiefung versehenen Deckelwafer 3 verkapselten volumenmikromechanisch gefertigten Mikrospiegel 12, der an Torsionsfedern 11 aufgehängt ist.
Fig. 4 zeigt die Schrittfolge zur Herstellung eines Deckelwafers 2 mittels Glasfließ-Verfahren.

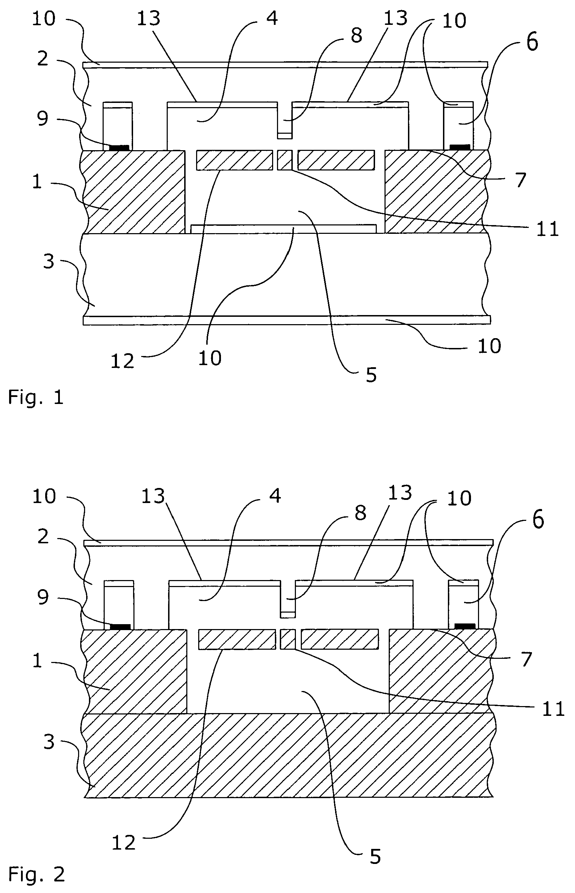

In Fig. 1 ist ein mit zwei transparenten Deckelwafern (Top-Deckelwafer 2 auf der Vorderseite des Trägerwafers und Bottom-Deckelwafer 3 auf der Rückseite des Trägerwafers) aus Borsilikatglas verkapselter volumenmikromechanisch gefertigter an Torsionsfedern 11 aufgehängter Mikrospiegel 12 aus Silizium im Querschnitt dargestellt, wobei Durchführungen durch den Trägerwafer 1 aus Silizium führen. Um ein hermetisch dichtes Gehäuse gewährleisten zu können, ist der Trägerwafer 1 beidseitig durch einen anodischen Bondprozess mit den Deckelwafern 2, 3 kontaktiert worden.

Zudem weist der Trägerwafer 1 für die Kontaktierung mit den Deckelwafern 2, 3 einen rahmenförmigen geschlossenen planaren Kontaktbereich 7 um den Mikrospiegel 12 herum auf. Ein entsprechend dimensionierter rahmenförmiger geschlossener planarer Kontaktbereich 7 ist bei den Deckelwafern als Gegenkontaktfläche vorgesehen.

Der Top-Deckelwafer 2 enthält Vertiefungen 4, die in Verbindung mit dem Trägerwafer 1 die für die Bewegungen des Mikrospiegels notwendigen Hohlräume 5 bilden.

Der an Torsionsfedern 11 aufgehängte Mikrospiegel 12 kann zum Beispiel einen Durchmesser von 10 mm haben. Bei einer maximalen Verkippung eines derartigen Mikrospiegels 12 um 10° sind Vertiefungen 4 im Top-Deckelwafer 2 von über 870 µm notwendig, so dass die tiefsten Vertiefungen 4, gemessen von den Kontaktbereichen 7 bis zum Boden dieser Vertiefungen 4, etwa 900 µm betragen. Die Böden der tiefsten Vertiefungen 4 bilden gleichzeitig die Bereiche, die als optische Fenster 13 fungieren. Für die mechanischen Anschläge 8 ist die Tiefe der Vertiefungen 4 so dimensioniert, dass die Anschläge zu den nicht ausgelenkten Torsionsfedern 11 einen vertikalen Abstand zwischen 1 µm und 50 µm aufweisen. Die Anschläge 8 haben keine optische Funktion. Sie gewährleisten nur eine mechanisch protektive Funktionalität des Topdeckel-Wafers 2. In der Ausführungsform nach Fig. 1 weist der Top-Deckelwafer 2 somit drei unterschiedlich Strukturhöhen zur Schaffung der optischen Fenster 13, der Anschläge 8 und der Kontaktbereiche 7 auf.

Die optischen Fenster 13 sowie die planare dem Mikrospiegel 12 abgewandte Seite des Top-Deckelwafers 2 sind mit einer Entspiegelungsschicht 10 aus einem Schichtsystem aus Magnesiumfluorid und Titandioxid versehen.

Der Bottom-Deckelwafer 3 ist nicht strukturiert ausgeführt und schließt den Hohlraum 5 um den Mikrospiegel 12 hermetisch dicht ab. Um auch diesseitig optische Funktionalität zu ermöglichen, wird auch der Bottom-Deckelwafer 3 beidseitig mit Entspiegelungsschichten 10 versehen. Dies würde beispielsweise die Möglichkeit bieten, auch die Rückseite des Mikrospiegels 12 zu bestrahlen und den reflektierten Strahl zur Bestimmung der Spiegelposition zu verwenden.

Mechanische Anschläge 8 sind im Bottom-Deckelwafer 3 nicht vorhanden, können aber in einer weiteren Ausgestaltung vorgesehen werden, um in beide Richtungen senkrecht zur Trägerwaferebene einen Überlastschutz zu gewährleisten.

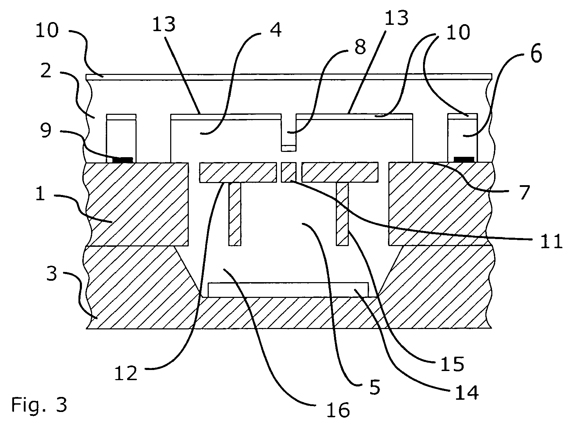

Hat der Bottom-Deckelwafer 3 keine optische Funktionalität zu erfüllen, kann ein handelsüblicher Siliziumwafer verwendet werden, wie in Fig. 2 und Fig. 3 gezeigt wird.

Wie Fig. 3 ebenfalls zeigt, wird in einer weiteren Ausgestaltung der Bottom-Deckelwafer 3 mit einer Vertiefung 16 versehen, um den Hohlraum 5 um den Mikrospiegel 12 zu vergrößern. Dies ist erforderlich, wenn der Mikrospiegel 12, wie in der hier dargestellten Ausgestaltung, Versteifungsstrukturen 15 zur Reduzierung statischer und dynamischer Deformationen und/oder Antriebsstrukturen 15, zum Beispiel für vertikale Antriebe und/oder in Waferdicke, besitzt. Zusätzlich wird die Vertiefung 16 im Bottom-Deckelwafer 3 dazu verwendet, um ein Getter-Material 14 (zum Beispiel Zirkonlegierungen, Titan), welches zur langfristigen Aufrechterhaltung eines Vakuums innerhalb des Hohlraums 5 dient, dort zu deponieren.

Eine weitere erfindungsgemäße Ausgestaltung sieht gemäß den Fig. 1-3 weitere Vertiefungen 6 im Top-Deckelwafer 2 außerhalb des den Mikrospiegel 12 einschließenden Hohlraums 5 vor. Diese Vertiefungen 6 umschließen nach der Verbindung von Trägerwafer 1 und Top-Deckelwafer 2 die Anschlussfelder (Pads) 9 eines jeden Chips. Durch geeigneten Schichtaufbau des Trägerwafers 1 lassen sich vergrabene Leiterbahnen unter dem Kontaktbereich 7 zwischen Trägerwafer 1 und Top-Deckelwafer 2 aus dem den Mikrospiegel 12 umschließenden Hohlraum 5 lateral zu den Anschlussfeldern 9 herausführen. Durch einen Sägeschritt, der nicht den vollständigen Waferverbund aus Trägerwafer 1 und Deckelwafern 2, 3 sondern nur den Top-Deckelwafer 2 im Bereich der Anschlussfelder 9 aufsägt, kann man die Anschlussfelder 9 zugänglich machen, ohne die Atmosphäre in dem den Mikrospiegel 12 einschließenden Hohlraum 5 zu beeinträchtigen. Das hat den Vorteil, dass noch vor dem Vereinzelungsschritt beispielsweise Funktionstests oder Messungen an dem fertig gekapselten Mikrospiegel 12 durchgeführt werden können.

Nach Bereitstellung des Trägerwafers 1 aus Silizium mit dem zu verkapselnden Mikrospiegel 12 werden beispielsweise zwei Glaswafer aus Borsilikatglas bereitgestellt, die als Top- 2 und Bottom-Deckelwafer 3 dienen. Die Glaswafer aus Borsilikatglas haben zum Beispiel eine Dicke zwischen 0,5 mm und 3 mm; unter anderem abhängig von der geforderten Stabilität.

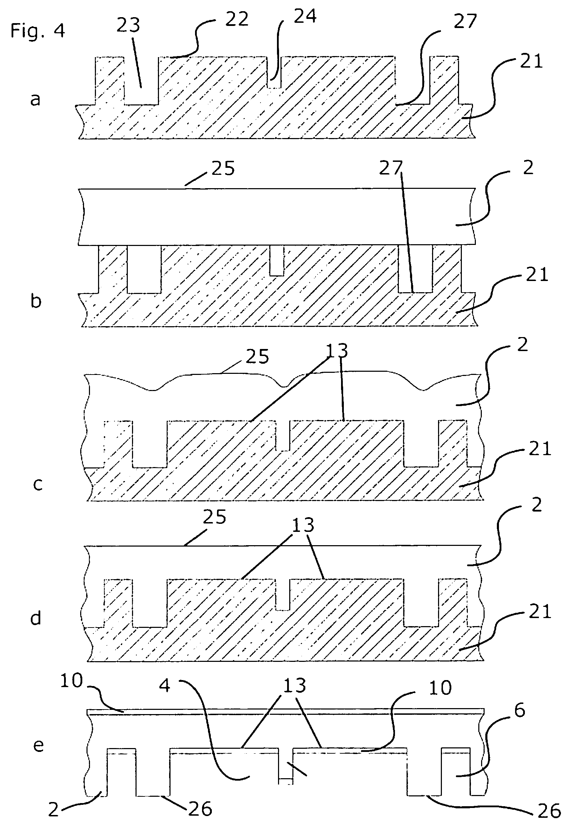

Fig. 4 zeigt die Schrittfolge zur Strukturierung des Top-Deckelwafers 2 mittels Glasfließ-Verfahren. Dabei werden die Strukturen eines Formwafers 21 auf den Top-Deckelwafer 2 abgeformt beziehungsweise übertragen.

Basis für den Formwafer 21 stellt ein einseitig polierter Siliziumwafer dar. Dieser Formwafer 21 bleibt in den Bereichen, durch die die optischen Fenster 13 geformt werden, unverändert, so dass die ursprüngliche Oberflächenqualität des polierten Siliziumwafers 21 erhalten bleibt. In den Bereichen, in denen die Kontaktbereiche 7 des Top-Deckelwafers 2 hergestellt werden, werden gleichmäßig tiefe Gräben 23 in den Formwafer 21 geätzt. Die Ätztiefe dieser Gräben 23 bestimmt in etwa die Tiefe des Hohlraums 5.

Hierfür kommen verschiedene Ätzverfahren in Frage. Sehr homogen über den gesamten Formwafer 21 ist dies beispielsweise zeitkontrolliert mit naßchemischen Ätzverfahren in Kaliumhydroxid (KOH) oder TMAH (Tetramethylammoniumhydroxid) zu erzielen. Aber auch Plasma gestützte Trockenätzverfahren können solche Gräben 23 mit hoher Präzision erzeugen; in der Regel jedoch unter der Voraussetzung, dass die Breite der Gräben 23 überall einheitlich ist.

Um ein Maximum an Homogenität der Grabentiefe und zugleich eine minimale Rauhigkeit der Grabenböden (27) zu erzielen, kann für den Formwafer 21 anstelle des Standard Siliziumwafers ein SOI-Wafer (Silicon on insulator - Wafer) entsprechender Dicke verwendet werden, wobei die Gräben 23 bis auf die verborgene Oxidschicht geätzt werden.

Um innerhalb der optischen Fenster 13 mechanische Anschläge 8 zu erzeugen, bedarf es weiterer zu ätzender Gräben 24 von geringerer Ätztiefe. Den fertig strukturierten Formwafer 21 zeigt Fig 4a.

Im nächsten Schritt wird auf den Formwafer 21 der Top-Deckelwafer 2 anodisch gebondet, wie Fig 4b zeigt. Um die Strukturen des Formwafers 21 vollständig abformen zu können, ist es in der Regel erforderlich, diesen Bondprozess im Vakuum durchzuführen.

Anschließend wird der Verbund aus Formwafer 21 und Top-Deckelwafer 2 in einem Ofen auf 600-800°C erhitzt. Dabei beginnt der Top-Deckelwafer 2 zu schmelzen und wird in Folge des Druckunterschieds zwischen Vakuum in den Gräben 23, 24 des Formwafers 21 und des höheren Umgebungsdrucks im Ofen in die Gräben 23, 24 des Formwafers 21 hineingedrückt, bis die Gräben 23, 24 des Formwafers 21 vollständig mit Borsilikatglas des Top-Deckelwafers 2 ausgefüllt sind. Auf diese Weise werden die Strukturen des Formwafers 21 vollständig auf den Top-Deckelwafer 2 abgeformt.

Bedingt durch den Glasfluss ist die vom Formwafer 21 abgewandte Seite des Top-Deckelwafers 2 nach dem Abkühlen nicht mehr plan (Fig 4c) und muss daher in einem präzisen Schleif- und Polierprozess planarisiert und geglättet werden, bis schließlich wieder optische Qualität erzielt ist. Das Ergebnis dieses Schritts ist in Fig 4d dargestellt. Im nächsten Schritt wird der polierte Top-Deckelwafer 2 von dem Formwafer 21 befreit, indem der Formwafer 21 nasschemisch weggeätzt wird.

Der Bottom-Deckelwafer 3 wird beidseitig plan oder mit einer Vertiefung 16 auf der dem Trägerwafer zugewandten Seite ausgeführt.

In einer vorteilhaften Ausgestaltung des Verfahrens werden auf die nach dem Bondprozess zur Trägerwaferebene parallelen Flächen der Deckelwafer 2, 3, die eine optische Funktion haben, Entspiegelungsschichten 10 aus einem Schichtsystem aus Magnesiumfluorid und Titanoxid aufgedampft. Diese Entspiegelungsschichten 10 müssen anschließend von den Kontaktbereichen 7 wieder entfernt werden (Fig 4e), da die Entspiegelungsschichten 10 den Bondprozess stören könnten.

Das Entfernen erfolgt durch eine Politur, die nur die Kontaktbereiche 7, nicht aber die Entspiegelungsschichten 10 in den Vertiefungen 4, 16 angreift.

Die Deckelwafer 2, 3 werden abschließend auf den Trägerwafer 1 gebondet.

### Bezugszeichenliste

- 1: Trägerwafer
- 2: Top-Deckelwafer
- 3: Bottom-Deckelwafer
- 4: Vertiefungen im Top-Deckelwafer
- 5: Hohlraum
- 6: Vertiefungen für die Anschlussfelder (Pads)
- 7: Kontaktbereich zwischen Trägerwafer und Top-Deckelwafer
- 8: mechanischer Anschlag
- 9: Anschlussfelder (Pads)
- 10: Entspiegelungsschicht
- 11: Torsionsfeder
- 12: Mikrospiegel
- 13: Optische Fenster
- 14: Getter-Material
- 15: Versteifungs- und/oder Antriebsstruktur
- 16: Vertiefung im Bottom-Deckelwafer
- 21: Formwafer
- 22: polierte Oberfläche für die optischen Fenster
- 23: Graben für Kontaktbereich
- 24: Graben für Anschlag
- 25: Rückseite des Top-Deckelwafers
- 26: Kontaktbereich des Top-Deckelwafers
- 27: Grabenboden für Kontaktbereich zwischen Trägerwafer und Top-Deckelwafer

## Patentansprüche

1. Gehäuse für ein oder mehrere mikromechanische und/oder mikrooptische Bauelemente (12), insbesondere bewegliche Mikrospiegel und/oder Mikrospiegel-Arrays, aufweisend ein Trägersubstrat (1) mit mindestens einem mikromechanischen und/oder mikrooptischen Bauelement (12) zur Verarbeitung elektromagnetischer Strahlung mit Wellenlängen, ausgewählt aus dem ultravioletten, sichtbaren und infraroten Wellenlängenbereich, und mindestens ein Deckelsubstrat (2, 3), das mit dem Trägersubstrat (1) in Verbindung steht und dessen dem mindestens einen mikromechanischen und/oder mikrooptischen Bauelement (12) zugewandte Seite ein optisches Fenster (13) und einen mechanischen Anschlag (8) aufweist, wobei durch das Trägersubstrat (1) und das mindestens eine Deckelsubstrat (2) mindestens ein Hohlraum (5) gebildet wird, der das mindestens eine mikromechanische und/oder mikrooptische Bauelement (12) zumindest teilweise einschließt, und wobei der mechanische Anschlag (8) einstückig mit dem Deckelsubstrat (2, 3) ausgebildet ist , **dadurch gekennzeichnet, dass** das optische Fenster (13) eine Ebenheitsabweichung kleiner einem Viertel der Wellenlänge der vom mikromechanischen und/oder mikrooptischen Bauelement (12) verarbeiteten Strahlung und kleiner gleich 180 nm, insbesondere kleiner gleich 110 nm, aufweist.

2. Gehäuse nach dem vorherigen Anspruch, **dadurch gekennzeichnet, dass** das mindestens eine Deckelsubstrat (2, 3) mindestens eine Vertiefung (4) aufweist, die tiefer als 900 µm ist.

3. Gehäuse nach einem der vorherigen Ansprüche, **dadurch gekennzeichnet, dass** das mindestens eine Deckelsubstrat (2, 3) zumindest in Teilbereichen Glas und/oder ein anderes Vitroid enthält oder daraus besteht.

4. Gehäuse nach Anspruch 3, **dadurch gekennzeichnet, dass** es sich bei dem Glas um ein Silikatglas, insbesondere ein Borsilikatglas, handelt.

5. Gehäuse nach einem der vorherigen Ansprüche, **dadurch gekennzeichnet, dass** das optische Fenster (13) eine quadratische Oberflächenrauheit von kleiner gleich 15nm, insbesondere kleiner gleich 5 nm, aufweist.

6. Verfahren zur Herstellung eines Gehäuses zur Verkapselung ein oder mehrerer mikromechanischer und/oder mikrooptischer Bauelemente mit folgenden Schritten:
- Bereitstellen eines Trägersubstrats (1) mit mindestens einem mikromechanischen und/oder mikrooptischen Bauelement (12)
- Bereitstellen mindestens eines mittels Glasfließ-Verfahrens strukturierten Deckelsubstrats (2, 3), das mindestens ein optisches Fenster (13) und mindestens einen mechanischen Anschlag (8) aufweist, wobei bei der Strukturierung des Deckelsubstrats (2, 3) ein Formsubstrat (21) mit einem polierten Abformbereich (22) zur Abformung des optischen Fensters (13) bereitgestellt wird,
- Verbinden des Trägersubstrats (1) mit dem mindestens einen Deckelsubstrat (2, 3) derart, dass das Trägersubstrat (1) und das mindestens eine Deckelsubstrat (2, 3) mindestens einen Hohlraum (5) bilden, der das mindestens eine mikromechanische und/oder mikrooptische Bauelement (12) zumindest teilweise einschließt.

7. Verfahren nach Anspruch 6, **dadurch gekennzeichnet, dass** ein Gehäuse zur Verkapselung von mindestens einem mikromechanischen und/oder mikrooptischen Bauelement (12) zur Verarbeitung elektromagnetischer Strahlung mit Wellenlängen, ausgewählt aus dem ultravioletten, sichtbaren und infraroten Wellenlängenbereich, hergestellt wird.

8. Verfahren nach Anspruch 7, **dadurch gekennzeichnet, dass** der Abformbereich (22) derart poliert ist, dass durch die Abformung des Abformbereichs (22) auf das Deckelsubstrat (2, 3) ein optisches Fenster (13) erzeugt wird, dessen dem Abformbereich zugewandte Seite eine Ebenheitsabweichung kleiner einem Viertel der Wellenlänge der vom Bauelement (12) verarbeiteten Strahlung und kleiner gleich 180 nm, insbesondere kleiner gleich 110 nm, aufweist.

9. Verfahren nach einem der Ansprüche 6 bis 8, **dadurch gekennzeichnet, dass** der Abformbereich (22) derart poliert ist, dass durch die Abformung des Abformbereichs (22) auf das Deckelsubstrat (2, 3) ein optisches Fenster (13) erzeugt wird, dessen dem Abformbereich zugewandte Seite eine quadratische Oberflächenrauheit kleiner gleich 15 nm, insbesondere kleiner gleich 5 nm, aufweist.

10. Verfahren nach einem der Ansprüche 7 bis 9, **dadurch gekennzeichnet, dass** die vom Formsubstrat (21) abgewandte Seite des Deckelsubstrat (2, 3) nach der Abformung in einem Polierschritt planarisiert wird, wobei der Polierschritt insbesondere derart durchgeführt wird, dass die dadurch erzeugte Seite des optischen Fensters (13) eine Ebenheitsabweichung kleiner einem Viertel der Wellenlänge der vom Bauelement (12) verarbeiteten Strahlung und kleiner gleich 180 nm, insbesondere kleiner gleich 110 nm, aufweist.

11. Verfahren nach einem der Ansprüche 6 bis 10, **dadurch gekennzeichnet, dass** die vom Formsubstrat (21) abgewandte Seite des Deckelsubstrat (2, 3) nach der Abformung in einem Polierschritt planarisiert wird, wobei der Polierschritt insbesondere derart durchgeführt wird, dass die dadurch erzeugte Seite des optischen Fensters (13) eine quadratische Oberflächenrauheit kleiner gleich 15 nm, insbesondere kleiner gleich 5 nm, aufweist.

12. Verfahren nach einem der Ansprüche 6 bis 11, **dadurch gekennzeichnet, dass** das Formsubstrat (21) eine Vertiefung (24) zur Abformung des Anschlags (8) aufweist.

13. Verfahren nach einem der Ansprüche 6 bis 12, **dadurch gekennzeichnet, dass** das Verbinden des Trägersubstrats (1) mit dem mindestens einen Deckelsubstrat (2, 3) bei einem Druck unterhalb des atmosphärischen Luftdrucks erfolgt, insbesondere bei einem Druck zwischen etwa 10⁻³ mbar und etwa 1 mbar.

14. Verfahren nach einem der Ansprüche 6 bis 13, **dadurch gekennzeichnet, dass** das Verbinden des Trägersubstrats (1) mit dem mindestens einen Deckelsubstrat (2, 3) in einer Inertgas-Atmosphäre, die insbesondere Argon enthält oder daraus besteht, erfolgt.

15. Verwendung des Verfahrens nach den Ansprüchen 6 bis 14 auf Wafer-Ebene.

## Claims

1. Housing for one or more micro-mechanical and/or micro-optical components (12), in particular movable micro-mirrors and/or micro-mirror arrays, comprising a carrier substrate (1) with at least one micro-mechanical and/or micro-optical component (12) for processing electromagnetic radiation with wavelengths selected from the ultraviolet, visible and infrared wavelength range, and at least one cover substrate (2, 3), which is connected to the carrier substrate (1) and the side of which that is facing the at least one micro-mechanical and/or micro-optical component (12) has an optical window (13) and a mechanical stop (8), the carrier substrate (1) and the at least one cover substrate (2) forming at least one cavity (5), which at least partially encloses the at least one micro-mechanical and/or micro-optical component (12), and the mechanical stop (8) being formed in one piece with the cover substrate (2, 3), **characterized in that** the optical window (13) has a planarity deviation of less than one quarter of the wavelength of the radiation processed by the micro-mechanical and/or micro-optical component (12) and less than or equal to 180 nm, in particular less than or equal to 110 nm.

2. Housing according to the preceding claim, **characterized in that** the at least one cover substrate (2, 3) has at least one depression (4), which is deeper than 900 µm.

3. Housing according to one of the preceding claims, **characterized in that**, at least in partial regions, the at least one cover substrate (2, 3) contains or consists of glass and/or some other vitreous material.

4. Housing according to Claim 3, **characterized in that** the glass is a silicate glass, in particular a borosilicate glass.

5. Housing according to one of the preceding claims, **characterized in that** the optical window (13) has a root mean square surface roughness of less than or equal to 15 nm, in particular less than or equal to 5 nm.

6. Method for producing a housing for encapsulating one or more micro-mechanical and/or micro-optical components comprising the following steps:
- providing a carrier substrate (1), with at least one micro-mechanical and/or micro-optical component (12)
- providing at least one cover substrate (2, 3), which is structured by means of a glass flowing process and has at least one optical window (13) and at least one mechanical stop (8), a mould substrate (21) with a polished moulding region (22) being provided in the structuring of the cover substrate (2, 3) for the moulding of the optical window (13),
- connecting the carrier substrate (1) to the at least one cover substrate (2, 3) in such a way that the carrier substrate (1) and the at least one cover substrate (2, 3) form at least one cavity (5), which at least partially encloses the at least one micro-mechanical and/or micro-optical component (12).

7. Method according to Claim 6, **characterized in that** a housing for encapsulating at least one micro-mechanical and/or micro-optical component (12) for processing electromagnetic radiation with wavelengths selected from the ultraviolet, visible and infrared wavelength range is produced.

8. Method according to Claim 7, **characterized in that** the moulding region (22) is polished in such a way that the moulding of the moulding region (22) onto the cover substrate (2, 3) has the effect of creating an optical window (13), the side of which that is facing the moulding region has a planarity deviation of less than one quarter of the wavelength of the radiation processed by the component (12) and less than or equal to 180 nm, in particular less than or equal to 110 nm.

9. Method according to one of Claims 6 to 8, **characterized in that** the moulding region (22) is polished in such a way that the moulding of the moulding region (22) onto the cover substrate (2, 3) has the effect of creating an optical window (13), the side of which that is facing the moulding region has a root mean square surface roughness of less than or equal to 15 nm, in particular less than or equal to 5 nm.

10. Method according to one of Claims 7 to 9, **characterized in that** the side of the cover substrate (2, 3) that is facing away from the mould substrate (21) is planarized in a polishing step after the moulding, the polishing step being carried out in particular in such a way that the side of the optical window (13) that is created as a result has a planarity deviation of less than one quarter of the wavelength of the radiation processed by the component (12) and less than or equal to 180 nm, in particular less than or equal to 110 nm.

11. Method according to one of Claims 6 to 10, **characterized in that** the side of the cover substrate (2, 3) that is facing away from the mould substrate (21) is planarized in a polishing step after the moulding, the polishing step being carried out in particular in such a way that the side of the optical window (13) created as a result has a root mean square surface roughness of less than or equal to 15 nm, in particular less than or equal to 5 nm.

12. Method according to one of Claims 6 to 11, **characterized in that** the mould substrate (21) has a depression (24) for the moulding of the stop (8).

13. Method according to one of Claims 6 to 12, **characterized in that** the connecting of the carrier substrate (1) to the at least one cover substrate (2, 3) takes place at a pressure below the atmospheric air pressure, in particular at a pressure between approximately 10⁻³ mbar and approximately 1 mbar.

14. Method according to one of Claims 6 to 13, **characterized in that** the connecting of the carrier substrate (1) to the at least one cover substrate (2, 3) takes place in an inert gas atmosphere, which in particular contains or consists of argon.

15. Use of the method according to Claims 6 to 14 at wafer level.

## Revendications

1. Boîtier destiné à un ou plusieurs composant(s) micromécanique(s) et/ou micro-optique(s) (12), en particulier des micro-miroirs et/ou des réseaux de micro-miroirs mobiles, présentant un substrat de support (1) avec au moins un composant micromécanique et/ou micro-optique (12) pour le traitement d'un rayonnement électromagnétique avec des longueurs d'onde, choisies dans le domaine des longueurs d'onde ultraviolettes, visibles et infrarouges, et au moins un substrat de couvercle (2, 3), qui est assemblé au substrat de support (1) et dont le côté tourné vers ledit au moins un composant micromécanique et/ou micro-optique (12) présente une fenêtre optique (13) et une butée mécanique (8), dans lequel le substrat de support (1) et ledit au moins un substrat de couvercle (2) forment une cavité (5), qui contient au moins en partie ledit au moins un composant micromécanique et/ou micro-optique (12), et dans lequel la butée mécanique (8) est réalisée d'une seule pièce avec le substrat de couvercle (2, 3), **caractérisé en ce que** la fenêtre optique (13) présente un écart de planéité inférieur à un quart de la longueur d'onde du rayonnement traité par le composant micromécanique et/ou micro-optique (12) et inférieur ou égal à 180 nm, en particulier inférieur ou égal à 110 nm.

2. Boîtier selon la revendication précédente, **caractérisé en ce que** ledit au moins un substrat de couvercle (2, 3) présente au moins un creux (4), qui est plus profond que 900 nm.

3. Boîtier selon l'une quelconque des revendications précédentes, **caractérisé en ce que** ledit au moins un substrat de couvercle (2, 3) contient au moins dans des régions partielles du verre et/ou un autre vitroïde ou en est constitué.

4. Boîtier selon la revendication 3, **caractérisé en ce que** le verre est un verre de silicate, en particulier un verre de borosilicate.

5. Boîtier selon l'une quelconque des revendications précédentes, **caractérisé en ce que** la fenêtre optique (13) présente une rugosité superficielle moyenne quadratique inférieure ou égale à 15 nm, en particulier inférieure ou égale à 5 nm.

6. Procédé de fabrication d'un boîtier destiné à enfermer un ou plusieurs composant(s) micromécanique(s) et/ou micro-optique(s), comprenant les étapes suivantes:
- préparer un substrat de support (1) avec au moins un composant micromécanique et/ou micro-optique (12),
- préparer au moins un substrat de couvercle (2, 3) structuré au moyen d'un procédé de coulage de verre, qui présente au moins une fenêtre optique (13) et au moins une butée mécanique (8), dans lequel on prépare, lors de la structuration du substrat de couvercle (2, 3), un substrat de moule (21) avec une zone de moulage (22) pour le moulage de la fenêtre optique (13),
- assembler le substrat de support (1) audit au moins un substrat de couvercle (2, 3), de telle manière que le substrat de support (1) et ledit au moins un substrat de couvercle (2, 3) forment au moins une cavité (5), qui enferme au moins en partie ledit au moins un composant micromécanique et/ou micro-optique (12) .

7. Procédé selon la revendication 6, **caractérisé en ce que** l'on fabrique un boîtier destiné à enfermer au moins un composant micromécanique et/ou micro-optique (12) pour le traitement d'un rayonnement électro-magnétique avec des longueurs d'onde, choisies dans le domaine des longueurs d'onde ultraviolettes, visibles et infrarouges.

8. Procédé selon la revendication 7, **caractérisé en ce que** la zone de moulage (22) est polie, de telle manière que, par le moulage de la zone de moulage (22) sur le substrat de couvercle (2, 3), on produise une fenêtre optique (13), dont le côté tourné vers la zone de moulage présente un écart de planéité inférieur à un quart de la longueur d'onde du rayonnement traité par le composant (12) et inférieur ou égal à 180 nm, en particulier inférieur ou égal à 110 nm.

9. Procédé selon l'une quelconque des revendications 6 à 8, **caractérisé en ce que** la zone de moulage (22) est polie, de telle manière que, par le moulage de la zone de moulage (22) sur le substrat de couvercle (2, 3), on produise une fenêtre optique (13), dont le côté tourné vers la zone de moulage présente une rugosité superficielle moyenne quadratique inférieure ou égale à 15 nm, en particulier inférieure ou égale à 5 nm.

10. Procédé selon l'une quelconque des revendications 7 à 9, **caractérisé en ce que** le côté du substrat de couvercle (2, 3) détourné du substrat de moule (21) est planarisé après le moulage dans une étape de polissage, dans lequel l'étape de polissage est exécutée en particulier de telle manière que le côté de la fenêtre optique (13) ainsi produit présente un écart de planéité inférieur à un quart de la longueur d'onde du rayonnement traité par le composant (12) et inférieur ou égal à 180 nm, en particulier inférieur ou égal à 110 nm.

11. Procédé selon l'une quelconque des revendications 6 à 10, **caractérisé en ce que** le côté du substrat de couvercle (2, 3) détourné du substrat de moule (21) est planarisé après le moulage dans une étape de polissage, dans lequel l'étape de polissage est exécutée de telle manière que le côté de la fenêtre optique (13) ainsi produit présente une rugosité superficielle moyenne quadratique inférieure ou égale à 15 nm, en particulier inférieure ou égale à 5 nm.

12. Procédé selon l'une quelconque des revendications 6 à 11, **caractérisé en ce que** le substrat de moule (21) présente un creux (24) destiné au moulage de la butée (8).

13. Procédé selon l'une quelconque des revendications 6 à 12, **caractérisé en ce que** l'on effectue l'assemblage du substrat de support (1) avec ledit au moins un substrat de couvercle (2, 3) à une pression inférieure à la pression d'air atmosphérique, en particulier à une pression comprise entre environ 10⁻³ mbar et environ 1 mbar.

14. Procédé selon l'une quelconque des revendications 6 à 13, **caractérisé en ce que** l'on effectue l'assemblage du substrat de support (1) avec ledit au moins substrat de couvercle (2, 3) sous une atmosphère de gaz inerte, qui contient en particulier de l'argon ou en est constituée.

15. Utilisation du procédé selon l'une quelconque des revendications 6 à 14 sur un plan de galette.
